# EUROPÄISCHE PATENTSCHRIFT

(11) **EP 0 725 843 B1**
(45) Veröffentlichungstag und Bekanntmachung des Hinweises auf die Patenterteilung: **04.03.1998**
(21) Anmeldenummer: 94929464.9
(22) Anmeldetag: 11.10.1994
(51) Int. Cl.: C23C 14/30, C23C 14/32

(54) **VERFAHREN UND EINRICHTUNG ZUM PLASMAAKTIVIERTEN ELEKTRONENSTRAHLVERDAMPFEN**
PROCESS AND SYSTEM FOR PLASMA-ACTIVATED ELECTRON-BEAM VAPORISATION
PROCEDE ET SYSTEME DE VAPORISATION PAR BOMBARDEMENT ELECTRONIQUE ACTIVE AU PLASMA

(30) Priorität: 27.10.1993 DE 4336681
(43) Veröffentlichungstag der Anmeldung: 14.08.1996
(73) Patentinhaber: FRAUNHOFER-GESELLSCHAFT ZUR FÖRDERUNG DER ANGEWANDTEN FORSCHUNG E.V., 80636 München (DE)
(72) Erfinder: GOEDICKE, Klaus, D-01307 Dresden (DE); SCHEFFEL, Bert, D-01324 Dresden (DE); RESCHKE, Jonathan, D-01067 Dresden (DE); SCHILLER, Siegfried, D-01324 Dresden (DE); KIRCHHOFF, Volker, D-01324 Dresden (DE); WERNER, Torsten, D-01217 Dresden (DE)
(86) Internationale Anmeldenummer: DE9401207
(87) Internationale Veröffentlichungsnummer: WO9512005

(56) Entgegenhaltungen:
- EP-A- 0 384 617
- DE-A- 4 007 523
- DE-A- 4 217 450
- Patent Abstracts of Japan, Band 12, Nr 223(C-507); & JP,A,6320465 (NIPPON KOKAN K.K.), 1988-01-28

## Beschreibung

Die Erfindung betrifft ein Verfahren zum Verdampfen von Materialien im Vakuum aus zwei oder mehreren Tiegeln mittels Elektronenstrahl. Das Verfahren ist vorzugsweise zum Bedampfen großer Flächen geeignet und findet insbesondere Anwendung zum reaktiven Beschichten von Bauteilen, Werkzeugen und Bandstahl.

Beim Elektronenstrahlverdampfen wird ein hochenergetischer Elektronenstrahl mittels elektrischer oder magnetischer Felder abgelenkt und fokussiert und direkt auf die Oberfläche des zu verdampfenden Materials gerichtet. Ein entscheidender Vorteil des Elektronenstrahlverdampfens liegt darin begründet, daß die dampfabgebende Oberfläche direkt beheizt wird, ohne daß die Energiezufuhr über den Tiegel bzw. das Verdampfungsmaterial erfolgt. Das ermöglicht auch die Verwendung von wassergekühlten Kupfer-Tiegeln, wodurch Reaktionen zwischen Tiegelwand und Verdampfungsgut unterbunden werden. Ein weiterer wichtiger Grund für den Einsatz dieses Verfahrens ist die gute örtliche und zeitliche Steuerbarkeit des Elektronenstrahls, wodurch die Verwendung von großflächigen Verdampfertiegeln möglich wird. Mit entsprechend leistungsfähigen Elektronenstrahlkanonen vom Axialtyp werden höchste Verdampfungsraten realisiert.

Zur Abscheidung von Misch- und Legierungsschichten ist es bekannt, aus zwei oder mehreren Tiegeln, die mit unterschiedlichen Materialien gefüllt sind, gleichzeitig zu verdampfen. Die Verdampfungsraten aus den einzelnen Tiegeln werden durch Steuerung der Strahlleistung und Ablenkung so eingestellt, daß Schichten mit der erforderlichen Schichtzusammensetzung abgeschieden werden. Die Tiegel werden im zeitlichen Wechsel von einer oder mehreren Elektronenkanonen beaufschlagt. Mehrere Verdampfertiegel werden auch zur Beschichtung von sehr großen Substratflächen und zur Beschichtung mit sehr hoher Beschichtungsrate bei begrenzter Verdampfungsrate je Tiegel eingesetzt.

So ist es auch bekannt, in einem Rezipienten zwei Verdampfertiegel anzuordnen und mittels zwei Elektronenkanonen das Verdampfungsgut zu beaufschlagen. Der Elektronenstrahl wird mittels Magnetsystemen auf der Oberfläche des Verdampfungsgutes abgelenkt. Die Verdampfertiegel sind über variable ohmsche Widerstände mit dem auf Massepotential liegenden Rezipienten verbunden. Das Verdampfungsgut ist somit über die Tiegelwandungen kontaktiert und hat gleiches elektrisches Potential. Der Abstand der Verdampfertiegel ist so gewählt, daß sich deren Dampfwolken durchdringen (EP-A 0 384 617).

Ein Nachteil dieses Verfahrens der Elektronenstrahlverdampfung besteht in dem relativ geringen Anteil von angeregten und ionisierten Teilchen und der geringen Energie der verdampften Teilchen. Der Grund dafür ist die relativ geringe Temperatur an der dampfabgebenden Oberfläche. Ein weiterer Grund ist, daß der Wirkungsquerschnitt für den Stoß zwischen hochenergetischen Strahlelektronen und Dampfteilchen und damit die Ionisierungswahrscheinlichkeit im Dampf sehr gering ist. Wesentliche Voraussetzungen für die Abscheidung qualitativ hochwertiger, dichter Schichten - besonders bei niedriger Substrattemperatur und zur Herstellung von Verbindungsschichten durch reaktive Prozeßführung - ist jedoch gerade ein hoher Anregungs- und Ionisierungsgrad des Dampfes.

Es sind viele Verfahren zur plasmagestützten Schichtabscheidung bekannt, die die obengenannten Nachteile vermeiden sollen. Eines der bekanntesten ist die ionengestützte reaktive Verdampfung, bei welcher die auf der Schmelzbadoberfläche durch den primären energiereichen Elektronenstrahl erzeugten Streu- und Sekundärelektronen durch eine zusätzliche Elektrode beschleunigt werden. Die Elektrode wird auf ein geringes, positives Potential (20...100 V) gelegt und in der Verdampfungszone so angeordnet, daß auf dem Weg der Elektronen zur Anode möglichst viele Stöße zwischen Elektronen, Dampf- und Reaktivgasteilchen erfolgen können. Es bildet sich eine Glimmentladung aus, und ein Ionenstrom erreicht das Substrat. Die Energie der positiv ionisierten Teilchen kann zusätzlich durch eine an das Substrat gelegte negative Bias-Spannung erhöht werden (US 3,791,852).

Dieses Verfahren hat sich bisher jedoch technisch nicht durchgesetzt, da Versuche, den Prozeß großtechnisch durch den Einsatz von großen Verdampfertiegeln mit hohen Verdampferraten zu nutzen, gescheitert sind. Ein Hauptgrund dafür ist die vergleichsweise geringe Ionenstromdichte am Substrat.

Weiterhin ist eine Einrichtung bekannt, welche das obengenannte Prinzip dahingehend verbessern soll, daß stöchiometrische Schichten aus chemischen Verbindungen auch bei höheren Beschichtungsraten abgeschieden werden können. Diese Einrichtung ist dadurch gekennzeichnet, daß der Verdampfertiegel von einer Kammer umgeben ist, die in Richtung auf das Substrat eine Blendenöffnung aufweist. Außerhalb der Kammer ist eine positiv vorgespannte Elektrode angeordnet, welche die in der Innenkammer erzeugten Ladungsträger absaugt, wobei eine im Bereich von Blendenöffnung und Elektrode brennende Glimmentladung erzeugt wird (DE 36 27 151 A 1). Die Nachteile des Verfahrens liegen darin begründet, daß das Reaktivgas in die Innenkammer eingelassen wird und darin ein erhöhter Druck entsteht. Die angestrebten Wechselwirkungen zwischen Elektronenstrahl und Reaktivgas führen jedoch bei höheren Beschichtungsraten und den damit erforderlichen höheren Gasmengen zu einer starken Streuung des Elektronenstrahls. Der mit dieser Anordnung erreichbare Ionisierungsgrad ist für viele reaktive Beschichtungsprozesse zu niedrig. Außerdem schlägt sich ein großer Anteil des verdampften Materials auf der Wandung der Innenkammer ungenutzt nieder.

Weiterhin wurden, um diese Mängel zu beseitigen, effektive Elektronenquellen entwickelt, die mit geringen Beschleunigungsspannungen arbeiten. Dazu zählen die Niedervoltbogen-Verdampfer und Hohlkatoden-Elektronenstrahl-Verdampfer mit geheizter oder kalter Katode. Charakteristisch für diese Verfahren ist die Ausbildung des Tiegels als Anode einer elektrischen Entladung und der Einlaß eines Arbeitsgases (z. B. Argon) in einer separaten Katodenkammer. Da in der Beschichtungskammer ein geringer Gasdruck notwendig ist, müssen Druckstufen zwischen Katoden- und Beschichtungskammer angeordnet werden. Dazu ist auch ein Verfahren zum Verdampfen von Metallen beschrieben, bei welchem ein Elektronenstrahl eines Transverseverdampfers und ein Niedervoltbogen auf den als Anode geschalteten Tiegel gerichtet werden (DE 28 23 876 C 2). Gegenüber den Einzelverfahren können damit Verdampfungsrate und Ionisierung bzw. Anregung unabhängiger voneinander eingestellt werden. Die Plasmaaktivierung ist bei diesen Prozessen sehr intensiv, diese Verfahren sind technisch etabliert und liefern in der Praxis Schichten mit guten Eigenschaften. Beschichtungsraten über 1 µm/s wurden mit diesen Verfahren jedoch nicht erreicht. Die Übertragung dieser Verfahren auf ausgedehnte Tiegel zur Beschichtung großer Flächen wurde bisher nicht gelöst.

Es ist auch bekannt, Vakuumbogen-Verdampfer - auch Bogenverdampfer genannt - für Beschichtungsaufgaben einzusetzen (DE 31 52 736; US 4,673,477; DE 40 06 456). Ein Lichtbogen wird auf der Katode des Bogenverdampfers gezündet. Der Lichtbogen brennt im selbsterzeugten Dampf zwischen Katode und Anode, wobei sich die Entladung auf der Katodenseite in sogenannten Katodenflecken mit sehr hohen Stromdichten (j=10⁵...10⁸ A/cm²) zusammenschnürt. Die Katodenflecke, in denen sich die Aufschmelzung und Verdampfung des Targetmaterials vollzieht, bewegen sich stochastisch und sprunghaft über die Katodenoberfläche. Die mittlere Driftgeschwindigkeit und die Richtung dieser Bewegung werden vom Targetmaterial, vom Bogenstrom, äußeren magnetischen Feldern und der Anwesentheit zusätzlich eingebrachter Gase beeinflußt. Der entscheidende Vorteil dieses Verfahrens liegt in dem sehr hohen Ionisierungsgrad der erzeugten Dampfwolke (10...90 %) mit einem hohen Anteil an mehrfach ionisierten Teilchen. Mit diesem Verfahren aufgebrachte Schichten sind sehr dicht und weisen eine hohe Haftfestigkeit auf.

Diese Vorteile werden jedoch bei vielen Anwendungen durch den unerwünschten Einbau von zahlreichen Mikropartikeln bis ca. 50 µm Größe, den sogenannten Droplets, stark eingeschränkt. Diese Droplets werden aufgrund der überaus hohen Stromdichte in den Schmelzkratern an der Katodenoberfläche herausgeschleudert. Häufigkeit und Größe dieser Droplets können durch verschiedene Maßnahmen reduziert werden. Dazu zählen Methoden zur nachträglichen Filterung der Droplets mittels magnetischer oder elektrischer Umlenkfelder für geladene Partikel. Auch die Beschränkung der hohen Eigendynamik des katodischen Bogenfußpunktes durch Magnetfelder zum gleichmäßigen Abtragen der Tragetoberfläche unterdrückt oder vermeidet die Droplets. Das gleiche erreicht ein Elektronenstrahl zur Führung und Stabilisierung des Katodenfußpunktes. Die Bogenentladung wird dabei in einem Bereich betrieben, in dem ein wesentlicher Teil des Bogenstromes durch kleine Flecken auf der Targetoberfläche fließt und das Target als Katode geschaltet ist. Der Elektronenstrahl erzeugt eine lokale Dampfwolke über dem Target. Der Katodenfußpunkt wird in der lokalen Dampfwolke konzentriert und kann durch Ablenkung von Laser- bzw. Elektronenstrahl über die Targetoberfläche geführt werden.

Diese genannten Verfahren zum Bogenverdampfen führen zu keiner vollständigen Verhinderung der Dropletbildung und nennenswerten Erhöhung der Verdampfungsrate. Zur Aufrechterhaltung der elektrischen Entladung zur Plasmaaktivierung sind zusätzliche Elektroden erforderlich, die bei reaktiver Prozeßführung durch Bedeckung mit isolierenden Schichten unbrauchbar werden. Außerdem geht ein Teil der elektrischen Leistung der Entladung in diesen Elektroden verloren.

Schließlich ist auch eine Bogenentladung für Beschichtungszwecke bekannt, bei welcher die Anode als thermisch isolierter Tiegel ausgebildet ist und mit dem Elektronenstrom eines Bogens aufgeheizt wird, welcher auf einer separaten, kalten Katode brennt (DE 34 13 891 C 2). Auf dem heißen Verdampfungsgut der Anode konzentriert sich der Bogen zu sogenannten Anodenflecken und führt zu dessen intensiver Verdampfung, Anregung und Ionisierung. Der Bogen brennt vorwiegend im Dampf des anodischen Verdampfungsgutes. Diese Form der Bogenverdampfung vermeidet zwar die Entstehung von Droplets, aber die Nachteile sind die geringere Ionisierung des Dampfes, die Schwierigkeit, die gleichzeitig entstehenden Dämpfe von Anode und Katode zu trennen, und der notwendige Energieverbrauch zur Verdampfung von Katodenmaterial, das nicht zur Schichtbildung beiträgt.

Es ist auch ein Verfahren zum Verdampfen von Material im Vakuum bekannt, bei welchem das zu verdampfende Material in dem Verdampfertiegel mit hochenergetischen Elektronenstrahlen beaufschlagt wird und gleichzeitig das Material mit Elektronen aus einer Niedervoltbogenentladung zwischen einer Katode und einer in der Verdampfungskammer befindlichen Anode beschossen wird (DE 32 06 882 A 1). Mit diesem Verfahren werden zwar einige Mängel der bekannten Verfahren beseitigt, aber die Beschichtungsrate ist bei intensiver Plasmaeinwirkung zum Beschichten großer Substratflächen zu gering. Dieser Mangel ist auch dadurch begründet, daß die Energie der abgeschiedenen Teilchen unzureichend steuerbar ist, was letztendlich die Qualität der aufgebrachten Schicht mindert.

Der Erfindung liegt die Aufgabe zugrunde, ein Verfahren zum plasmaaktivierten Elektronenstrahlverdampfen zu schaffen, mit dem eine sehr hohe Beschichtungsrate bei intensiver Plasmaeinwirkung erreicht wird. Es sollen ein hoher Ionisierungs- und Anregungsgrad des erzeugten Dampfes möglich und das Spektrum der abscheidbaren Materialien sehr groß sein. Das Verfahren soll insbesondere eine reaktive Prozeßführung, auch zur Abscheidung von elektrisch isolierenden Schichten, ermöglichen. Dabei sollen keine zusätzlichen Elektroden verwendet werden, welche während des Beschichtungsprozesses mit isolierenden Schichten bedeckt und dadurch unwirksam werden. Das Verfahren soll einen guten Wirkungsgrad hinsichtlich der umgesetzten elektrischen Leistung haben. Die Beschichtung großer Substrat flächen soll durch große Verdampferflächen möglich sein, und dabei sollen sich die Beschichtungsrate, die Ionenstromdichte am Substrat und die mittlere Energie der abgeschiedenen Teilchen gut steuern lassen.

Erfindungsgemäß wird die Aufgabe nach den Merkmalen des Patentanspruches 1 gelöst. Weitere Ausgestaltungen des Verfahrens zeigen die Patentansprüche 2 bis 11.

Das erfindungsgemäße Verfahren nutzt die Besonderheiten dieser speziellen elektrischen Entladung, aus denen sich die Vorteile des Verfahrens ergeben. Die Entladung brennt im Dampf des Verdampfungsmaterials und dient damit unmittelbar der Aktivierung des Dampfes. Zur Aufrechterhaltung der Entladung wird kein zusätzliches Prozeßgas benötigt. Deshalb ist das Verfahren zur plasmagestützten Abscheidung sehr reiner Schichten besonders geeignet. Es kann für bestimmte Anwendungsfälle zweckmäßig sein, bis zu einem bestimmten Druck zusätzliches Inertgas, vorzugsweise Argon, in die Verdampfungszone einzulassen, wodurch die Entladungsbedingungen und die Schichtbildung beeinflußt werden. Weiterhin ist dieses Verfahren hervorragend zur reaktiven Prozeßführung geeignet. In diesem Fall wird in bekannter Weise ein Reaktivgas (z. B. N₂, O₂) in den Rezipienten eingelassen. Die Bogenentladung erzeugt eine solche hohe Plasmadichte, daß verstärkt Reaktionen zwischen Reaktivgasteilchen und abgeschiedenen Dampfteilchen sowohl am Substrat als auch in der Verdampfungszone erfolgen. Es können stöchiometrische Schichten abgeschieden werden, wenn Verdampfungsrate und Reaktivgaseinlaß geeignet aufeinander abgestimmt sind. Diese Schichten aus chemischen Verbindungen, welche sich natürlich auch auf allen anderen Oberflächen im Verdampfungsraum niederschlagen, können auch elektrisch isolierend (z. B. oxidisch) sein. Solche isolierenden Schichten können die beschriebene Entladungsform nicht beeinträchtigen, da beide Elektroden heiß und dampfabgebend sind und durch den Elektronenstrahl und die Entladung selbst ständig freigehalten werden. Das Problem der Kontamination der Elektroden während des Prozesses, das eine Prozeßunterbrechung herbeiführt, tritt nach dem erfindungsgemäßen Verfahren nicht auf.

Ein weiterer Vorteil besteht darin, daß die gesamte elektrische Leistung der Bogenentladung im Prozeß genutzt wird. Für die elektrische Entladung wirken ausschließlich Elektroden, welche direkt am Prozeß der Verdampfung und Plasmaaktivierung beteiligt sind. Sowohl der katodische als auch der anodische Bogenansatz sind auf die heißen und verdampfenden Bereiche der Oberfläche des Verdampfungsgutes konzentriert. Wärmeenergie, die durch die elektrodennahen Prozesse in die Anode bzw. die Katode übergeht, führt damit zu einer noch intensiveren Verdampfung der Elektroden. Der Anteil der elektrischen Leistung der Bogenentladung, der in der Plasmazone umgesetzt wird, hält die Ionisierungs- und Anregungsprozesse im Dampf aufrecht.

Mit dem Verfahren werden dropletfreie und dichte Schichten abgeschieden. Die Dropletemission von Bogenentladungen ist eng an Katodenmechanismen mit sehr hohen Stromdichten gekoppelt. Durch bestimmte Betriebsbedingungen, die mit einer sehr hohen Dampfdichte und hoher Katodentemperatur verbunden sind, läßt sich die Ausbildung von Katodenflecken verhindern. Es bildet sich ein intensives, über den heißen und verdampfenden Teilen der Katodenoberfläche weitgehend gleichmäßig verteiltes Plasma aus. Der Bogenansatz im Bereich der Katode hat in diesem Fall diffusen Charakter, verbunden mit relativ geringen Stromdichten (j = 10...1000 A/cm²). Die für Vakuum-Bogenentladungen sonst typischen nichtstationären Erscheinungen wie stochastische Katodenfleckbewegung, häufiges Verlöschen der Entladung, starke Schwankungen von Brennspannung und Plasmaintensität werden bei diesem erfindungsgemäßen Verfahren weitgehend vermieden.

Weitere besondere Vorteile des Verfahrens hängen damit zusammen, daß der Elektronenstrahl sehr schnell abgelenkt werden kann und innerhalb gewisser Grenzen beliebige lineare und flächige Figuren auf dem Verdampfungsgut zeichnen kann, die den Fußpunktbereich für den diffusen Bogen bilden. Zur Erzielung einer bestimmten Leistungsdichte kann der Elektronenstrahl fokussiert oder defokussiert werden. Damit können der Ort sowie die Fläche und folglich die Stromdichte des katodischen Ansatzes der diffusen Bogenentladung gesteuert werden. Es lassen sich vor allem auch großflächig ausgedehnte Plasmabereiche erzeugen, während das Problem von flächenhaft ausgedehnten Plasmaquellen bisher meistens durch eine Aneinanderreihung mehrerer einzelner Plasmaquellen mit zugehörigen separaten Stromversorgungen gelöst wurde. Das Verfahren läßt es überraschenderweise zu, den Bogen auf der Katodenoberfläche in mehrere räumlich voneinander getrennte Gebiete zu teilen, indem durch den Elektronenstrahl verschiedene Gebiete der Oberfläche nacheinander, aber durch eine hohe Wechselfrequenz bedingt quasi gleichzeitig beheizt werden. Auch auf dem anodisch wirkenden Verdampfungsgut lassen sich durch Elektronenstrahlablenkung mehrere verschiedene Gebiete beheizen. Somit können auch räumlich ausgedehnte, große Verdampfertiegel für die Beschichtung von großflächigen Substraten verwendet werden. Mehrere getrennte Gebiete auf der Oberfläche des Verdampfungsgutes können durch ein einziges Verdampfersystem (Elektronenkanone mit Ablenksystem) und ein gemeinsames Plasma-Stromversorgungssystem aktiviert werden.

Zur Verdampfung von Metallen und Legierungen oder zur Abscheidung von Verbindungsschichten mittels reaktiver Verdampfung eines Metalls werden die Verdampfertiegel mit dem gleichen Verdampfungsgut gefüllt. Zur Abscheidung von Misch- oder Legierungsschichten durch Ko-Verdampfung werden die beteiligten Verdampfertiegel mit unterschiedlichen Verdampfungsmaterialien gefüllt. Durch unabhängige Einstellung von Elektronenstrahlleistung, Ablenkung und Fokussierung für jeden der beteiligten Tiegel kann die Schichtzusammensetzung gezielt beeinflußt werden. Die elektrische Entladung kann bei entsprechender Dampfdichte auch über die sich durchdringenden Dampfwolken unterschiedlicher Materialien betrieben werden.

Die anodischen und katodischen Prozesse liefern unterschiedliche Beiträge zur Plasmaaktivierung und Verdampfung. Bei den meisten Materialien findet in Katodennähe die intensivere Plasmaerzeugung statt. Eine vorteilhafte Ausgestaltung des Verfahrens besteht vor allem darin, daß jeder Verdampfertiegel abwechselnd als Anode oder Katode geschaltet wird. Im Wechselspannungssbetrieb ergibt sich der Vorteil, daß die jeweils beteiligten Verdampfertiegel im zeitlichen Mittel gleichartig wirken. Die Verdampfertiegel sind gleichermaßen an den Prozessen zur Plasmaaktivierung beteiligt, was besonders bei der Verdampfung aus mehreren mit unterschiedlichen Materialien gefüllten Verdampfertiegeln von Bedeutung ist. Gegenüber der Gleichstrom-Variante des Verfahrens ergibt sich im Wechselspannungsbetrieb außerdem eine weitaus symmetrische Plasmaverteilung im Verdampfungsraum zwischen den Verdampfertiegeln. Im einfachsten Fall wird eine sinusförmige Wechselspannung zwischen zwei Verdampfertiegeln angelegt. Die Bogenstromversorgung wird vorzugsweise als bipolare Pulsstromversorgung ausgelegt. Damit sind beliebige Pulsformen, Pulsamplituden und unterschiedliche Pulslängen und Pulspausen für positive und negative Polung möglich. Daraus ergibt sich die Möglichkeit, Verdampfungsparameter (Verdampfungsrate durch Elektronenstrahl-Leistung, Fokussierung und Ablenkung) und Plasmaparameter (Ionisierung- und Anregungsgrad durch Bogenentladung) weitgehend unabhängig voneinander und für jeden Verdampfertiegel getrennt einzustellen und den energetischen und reaktionskinetischen Bedingungen des jeweiligen Beschichtungsprozesses anzupassen.

Zur Energieerhöhung der auf das Substrat treffenden Ionen wird in an sich bekannter Weise an das Substrat eine gegenüber den Verdampfertiegeln negative Bias-Spannung angelegt. Bei sehr großen Substrat flächen erreicht der dadurch erzeugte Bias-Strom Werte von z. B. 100 A. Aufladungen können unter bestimmten Bedingungen dazu führen, daß sich der Strom zum Substrat spontan zu einer Bogenentladung mit Katodenflecken auf dem Substrat zusammenschnürt. Um solche Erscheinungen zu verhindern oder entstandene Bögen sofort wieder zu löschen, wird auch die Bias-Stromversorgung gepulst ausgeführt. Wird die Entladung zwischen den Tiegeln mit Wechselstrom betrieben, so ist es zweckmäßig, die Biasspannung mit der doppelten Frequenz gegenüber der Frequenz der Wechselstromentladung mit zeitsynchronen Nulldurchgängen beider Spannungen zu betreiben.

An drei Ausführungsbeispielen wird die Erfindung näher erläutert. Die zugehörigen Zeichnungen zeigen:

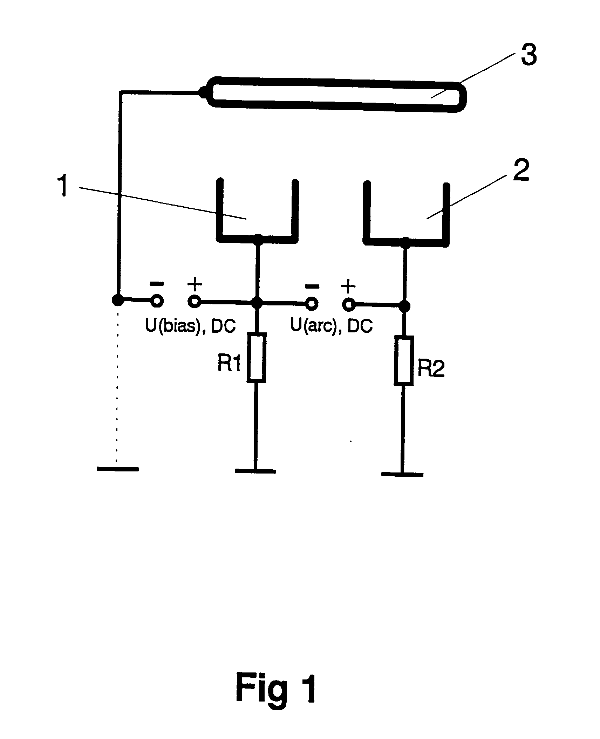

In Fig. 1 ist die einfachste Variante des Verfahrens dargestellt. Es soll durch plasmagestützte Abscheidung eine dichte und korrosionsbeständige Titanschicht auf Stahlblech mit einer Gleichstromentladung erzeugt werden. Es werden zwei Verdampfertiegel 1; 2 verwendet, die mit Ti als Verdampfungsgut gefüllt sind. Der Elektronenstrahl (100 kW bei 40 kV) beheizt wechselweise das Verdampfungsgut von Verdampfertiegel 1 und 2 mit einer Verweilzeit von je 20 ms. Der Elektronenstrahl überstreicht durch schnelle Ablenkung auf beiden Verdampfertiegeln 1; 2 eine Fläche von je ca. 30 cm². Die Verdampfertiegel 1; 2 sind über die Widerstände R 1 und R 2 jeweils mit dem Massepotential verbunden und dienen der Ableitung des Elektronenstrahlstroms. Die Größe der Widerstände R 1 und R 2 muß zwei Bedingungen erfüllen: Erstens muß der Spannungsabfall, der am Widerstand durch den abgeleiteten Elektronenstrahlstrom I(ES) entsteht, klein gegenüber der Elektronenstrahl-Beschleunigungsspannung U(ES) sein; d. h. R 1 = R 2 << U(ES) / I(ES). Zweitens soll der Verluststrom durch die Widerstände R 1 und R 2, der nach Anlegen der Bogenspannung U(arc) an die Verdampfertiegel 1; 2 entsteht, klein gegenüber dem Bogenstrom I(arc) sein, d. h. (R 1 + R 2) >> U(arc) / I(arc). Die Größe der Widerstände R 1; R 2 wurde zu jeweils 20 Ω gewählt. Zwischen den Verdampfertiegeln 1; 2 wird die Bogen-Gleichspannung U(arc) mit dem negativen Pol am Verdampfertiegel 1 angelegt. Der Verdampfertiegel 1 dient also als Katode, Verdampfertiegel 2 als Anode der Entladung. Zwischen Verdampfertiegel 1 und dem Substrat 3 liegt die Biasspannnung U(bias) mit dem negativen Pol am Substrat 3; dem Stahlblech. Gegenüber dem Verdampfertiegel 2 ist die Biasspannung des Substrates 3 um die Bogenspannung U(arc) erhöht. Das Substrat 3 kann wahlweise auch auf Massepotential gelegt werden (gestrichelte Linie). Die Bogenentladung wird bei einer Stromstärke von 600 A betrieben, hat auf der Katodenseite einen diffusen Bogenansatz auf einer Fläche von ca. 30 cm² und brennt ausschließlich im Titandampf. Das Substrat 3 wird in einem Abstand von 30 cm über die Verdampfungszone bewegt. Es entsteht eine dichte und gut haftfeste Titan-Schicht.

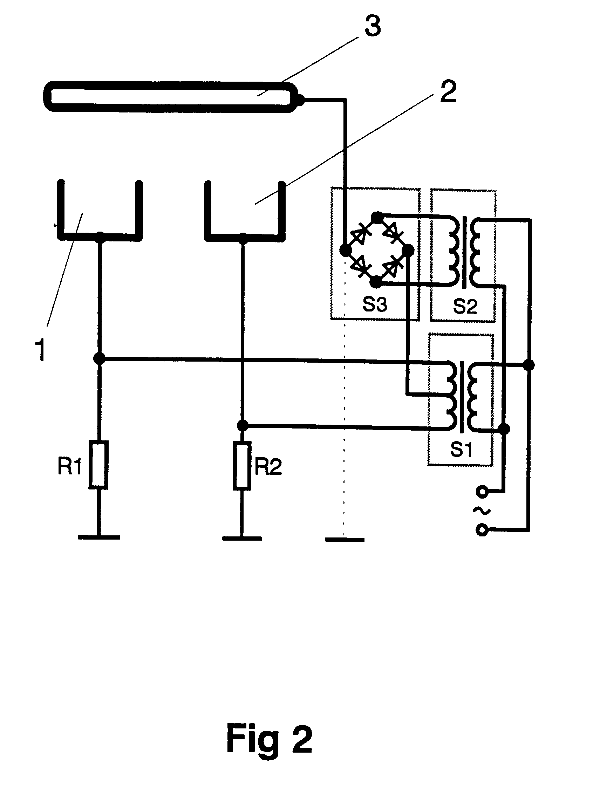

Anhand von Fig. 2 wird eine Verfahrensvariante zur plasmagestützten Abscheidung von Titanoxid-Schichten auf Stahlblech mit einer durch einen Sinus-Wechselstrom gespeisten Entladung erläutert. Es werden zwei Verdampfertiegel 1; 2 mit Titan gefüllt. Der Elektronenstrahl beheizt wechselweise das Verdampfungsgut von Verdampfertiegel 1 und 2 mit einer Verweilzeit von je 10 ms durch schnelle Ablenkung auf einer Fläche von je ca. 30 cm². Die zwei Verdampfertiegel 1; 2 sind über die Widerstände R 1 und R 2 jeweils mit dem Massepotential verbunden und dienen der Ableitung des Elektronenstrahlstroms. Die Dimensionierung der Widerstände R 1; R 2 erfolgt wie im Beispiel 1. Die Stromversorgungseinheit S 1 überträgt eine sinusförmige Wechselspannung an die Verdampfertiegel 1 und 2. Sie dienen damit abwechselnd mit der Frequenz der Sinusspannung von 1000 Hz als Anode bzw. Katode der Bogenentladung. Die Biasspannung ist mittels der Stromversorgungseinheiten S 2 und S 3 gepulst ausgeführt. Als Speisespannung wird dafür dieselbe Wechselspannung wie zur Speisung der Bogenstromversorgungseinheit S 1 verwendet. Sie wird mit der Stromversorgungseinheit S 2 transformiert und mit der Stromversorgungseinheit S 3 gleichgerichtet. Die entstandenen Sinus-Halbwellen-Impulse (negative Polarität am Substrat) mit gegenüber der Eingangs-Sinusspannung doppelter Frequenz werden auf eine Mittelanzapfung des Ausgangsübertragers der Stromversorgungseinheit S 1 geschaltet. Diese Schaltungsanordnung hat den Vorteil, daß Bias-Impulsspannung und Bogen-Wechselspannung genau miteinander synchronisiert sind, d. h. die Nullstellen von Bias- und Bogen-Spannung treffen zeitlich aufeinander. Zur Stützung der Entladung wird in die Verdampfungszone Argon bei einem Druck von ca. 0,2 Pa eingelassen. Die Bogenentladung wird bei einer Stromstärke von 600 A betrieben und hat auf dem Verdampfungsgut beider Tiegel 1; 2 einen diffusen Ansatz. Außerdem wird Sauerstoff bis zu einem Totaldurck von 1 Pa in die Verdampfungszone eingelassen, wodurch eine stöchiometrische Schicht aus Titanoxid auf dem Substrat 3 entsteht.

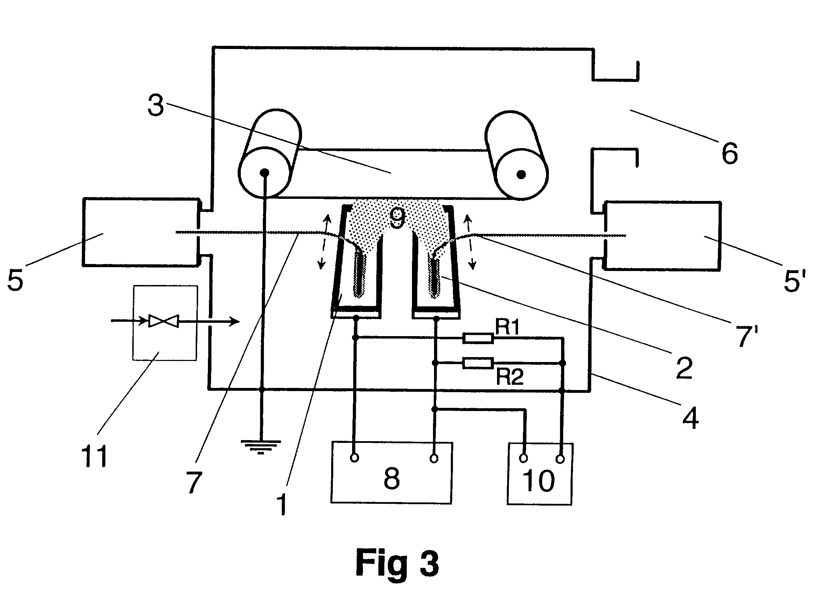

Anhand von Fig. 3 wird eine Einrichtung zur Beschichtung von Bandstahl (Substrat 3) mit Titanoxid aus zwei großen rechteckförmigen Verdampfertiegeln erläutert. An einem Rezipienten 4, der über den Vakuum-Punpstutzen 6 bis zu einem Druck von 10⁻³ Pa evakuiert wird, sind zwei Elektronenkanonen 5; 5' angeflanscht. Die Elektronenkanonen 5; 5' beheizen jeweils einen von zwei wassergekühlten Verdampfertiegeln 1 und 2 der Abmessungen 500 mm x 200 mm mit einer Elektronenstrahlleistung von jeweils 200 kW. Zwei unabhängige Magnetsysteme (nicht dargestellt) erzeugen statische Magnetfelder, welche die horizontal eingeschossenen Elektronenstrahlen 7; 7' auf die Verdampfertiegel ablenken. Ablenksysteme in den Elektronenkanonen 5; 5' ermöglichen die programmierte Ablenkung der Elektronenstrahlen 7; 7' über die gesamte Tiegellänge. Die Verdampfertiegel 1; 2 sind über die ohmschen Widerstände R 1; R 2 mit Massepotential verbunden. Zwischen diese Verdampfertiegel 1; 2 wird eine Wechsel-Pulsspannung von 100 Hz gelegt, die von der Stromversorgung 8 geliefert wird. Bei einem Abstand von 5 cm sind die Verdampfertiegel 1; 2 ausreichend nahe nebeneinander angeordnet, so daß sich ihre Dampfwolken durchdringen. Es zündet ohne zusätzliche Zündeinrichtung und ohne Einlaß eines Prozeßgases eine stromstarke Bogenentladung, die bei ca. 50 V Brennspannung und einer Stromstärke von 2000 A betrieben wird. Ein intensiv leuchtendes diffuses Plasma 9 bildet sich über beiden Verdampfertiegeln 1; 2 gleichermaßen aus und erfüllt den Verdampfungsraum zwischen der Tiegelebene und der 40 cm höher gelegenen Substratebene. Zwischen einem der Verdampfertiegel 1; 2 und dem Substrat 3 wird eine gepulste Bias-Spannung mit einer Amplitude von 300 V gelegt, die von der Stromversorgung 10 geliefert wird. Diese gegenüber Masse positive Bias-Spannung hat die doppelte Frequenz wie die Bogen-Wechselspannung. Über das Gaseinlaßsystem 11 wird Sauerstoff in die Verdampfungszone eingelassen. Das Substrat 3 befindet sich auf Massepotential und wird mit energiereichen Ionen und Neutralteilchen aus der Verdampfungszone beschossen, die mit den Sauerstoffteilchen reagieren und eine dichte Titanoxid-Schicht auf dem Substrat 3 bilden.

## Patentansprüche

1. Verfahren zum plasmaaktivierten Elektronenstrahlverdampfen, indem Verdampfungsgut aus mindestens zwei Verdampfertiegeln, an welche eine elektrische Spannung angelegt ist, durch Einwirkung von Elektronenstrahlen verdampft wird, **dadurch gekennzeichnet,** daß die an die Verdampfertiegel gelegte elektrische Spannung eine Wechselspannung beliebiger Pulsform ist, so daß Katode und Anode ständig gewechselt werden, daß dadurch die durch die Elektronenstrahlen geheizten und dampfabgebenden Bereiche des Verdampfungsgutes als Elektroden einer elektrischen Entladung wirken und dabei das Verdampfungsgut mindestens eines Verdampfertiegels als Katode und das Verdampfungsgut mindestens eines weiteren Verdampfertiegels als Anode geschaltet wird.

2. Verfahren nach Anspruch 1, **dadurch gekennzeichnet,** daß die Amplitude, Form und Dauer der Pulse sowie die Pulspausenzeiten der Wechselspannung für jede Polarität der Pulse getrennt gesteuert werden.

3. Verfahren nach Anspruch 1 und 2, **dadurch gekennzeichnet,** daß auf dem Verdampfungsgut innerhalb eines Verdampfertiegels die Elektronenstrahlen derart programmiert abgelenkt werden, daß auf dem Verdampfungsgut mehrere quasi gleichzeitig beheizte Bereiche entstehen und über jeden Bereich ein Teil des Entladungsstromes fließt.

4. Verfahren nach Anspruch 1 bis 3, **dadurch gekennzeichnet,** daß zur Stützung der Entladung ein Anteil eines inerten Gases, vorzugsweise Argon, in den Entladungsraum eingebracht wird.

5. Verfahren nach Anspruch 1 bis 4, **dadurch gekennzeichnet,** daß die Verdampfertiegel mit gleichem oder unterschiedlichem Material gefüllt werden.

6. Verfahren nach Anspruch 1 bis 5, **dadurch gekennzeichnet,** daß zur Herstellung von Verbindungsschichten während des Verdampfungsprozesses ein Reaktivgas eingelassen wird.

7. Verfahren nach Anspruch 1 bis 6, **dadurch gekennzeichnet,** daß das Verhältnis der elektrischen Leistung der Elektronenstrahlen zur Leistung der elektrischen Entladung frei wählbar eingestellt wird.

8. Verfahren nach Anspruch 1 bis 7, **dadurch gekennzeichnet,** daß an die zu bedampfenden Substrate ein frei wählbares Potential angelegt wird.

9. Verfahren nach Anspruch 8, **dadurch gekennzeichnet,** daß an einem zu bedampfenden Substrat gegenüber den Verdampfertiegeln eine negative Gleichspannung angelegt wird.

10. Verfahren nach Anspruch 8, **dadurch gekennzeichnet,** daß an die zu bedampfenden Substrate gegenüber den Verdampfertiegeln eine gepulste negative Gleichspannung mit einstellbarer Pulsform, Pulsamplitude, Pulsdauer und Pulspausenzeit angelegt wird.

11. Verfahren nach mindestens einem der Ansprüche 1 bis 10, **dadurch gekennzeichnet,** daß die Entladungswechselspannung und die gepulste Substratspannung auf zeitgleiche Nulldurchgänge synchronisiert werden und die Frequenz der Substratspannung doppelt so groß wie die Frequenz der Entladungswechselspannung eingestellt wird.

## Claims

1. Method for plasma-activated electron beam vaporisation, in which material for vaporisation is vaporised out of at least two vaporising crucibles, to which there is applied an electric voltage, by the action of electron beams, characterised in that the electrical voltage applied to the vaporising crucibles is an alternating voltage of optional pulse configuration, so that the cathode and the anode are continuously interchanged, in that in this way the areas of the material to be vaporised which emit vapour and are heated by the electron beams, act as electrodes of an electrical discharge, and thus the material for vaporisation of at least one vaporising crucible is connected as cathode, and the material for vaporisation of at least one further vaporisation crucible is connected as anode.

2. Method according to claim 1, characterised in that the amplitude, shape and pulse duration and the pulse intervals of the alternating voltage are separately controlled for each polarity of the pulses.

3. Method according to claim 1 and 2, characterised in that the electron beams are deflected in a programmed fashion on the material for vaporisation inside a vaporising crucible, in such a way that a plurality of so to speak simultaneously heated areas occur on the material for vaporisation, and a portion of the discharge current flows through each area.

4. Method according to claim 1 to 3, characterised in that, in order to reinforce the discharge, a proportion of an inert gas, preferably argon, is introduced into the discharge space.

5. Method according to claim 1 to 4, characterised in that the vaporising crucibles are filled with the same or a different material.

6. Method according to claim 1 to 5, characterised in that a reactive gas is introduced in order to produce connecting layers during the vaporisation process.

7. Method according to claim 1 to 6, characterised in that the ratio of the electrical power of the electron beams to the power of the electrical discharge is freely selectable.

8. Method according to claim 1 to 7, characterised in that a freely selectable potential is applied to the substrates to be vapour-deposited.

9. Method according to claim 8, characterised in that a negative direct voltage is applied to a substrate to be vapour-deposited, opposite the vaporising crucibles.

10. Method according to claim 8, characterised in that a pulsed negative direct voltage with adjustable pulse shape, pulse amplitude, pulse duration and pulse interval is applied to the substrate to be vapour-deposited, opposite the vaporising crucibles.

11. Method according to at least one of claims 1 to 10, characterised in that the discharge alternating voltage and the pulsed substrate voltage are synchronised to simultaneous passages through zero, and the frequency of the substrate voltage is adjusted to be twice as high as the frequency of the discharge alternating voltage.

## Revendications

1. Procédé d'évaporation par des faisceaux d'électrons activés par un plasma, selon lequel on évapore un produit provenant d'au moins deux creusets d'évaporation mis sous tension électrique, en faisant agir des faisceaux d'électrons,
caractérisé en ce que
• la tension électrique appliquée aux creusets est une tension alternative de n'importe quelle forme impulsionnelle pour que la cathode et l'anode alternent en permanence,
• les plages du produit à évaporer, chauffées par faisceau d'électrons et générant de la vapeur fonctionnent comme les électrodes pour une décharge électrique, et
• le produit à évaporer d'au moins un creuset est branché comme cathode et le produit à évaporer d'au moins un autre creuset est branché comme anode.

2. Procédé selon la revendication 1,
caractérisé en ce que
l'amplitude, la forme, la durée des impulsions et l'intervalle entre les impulsions de la tension alternative sont commandés séparément pour chaque polarité des impulsions.

3. Procédé selon la revendication 1 ou 2,
caractérisé en ce qu'
à l'intérieur d'un creuset d'évaporation on dévie de manière programmée les faisceaux d'électrons arrivant sur le produit à évaporer pour que le produit à évaporer forme plusieurs zones chauffées de manière quasi simultanée et que chacune des zones soit traversée par une partie du courant de décharge.

4. Procédé selon les revendications 1 à 3,
caractérisé en ce que
pour soutenir la décharge, une partie d'un gaz inerte, de préférence de l'Argon est introduite dans la chambre de décharge.

5. Procédé selon les revendications 1 à 4,
caractérisé en ce qu'
on remplit les creusets à évaporer d'une matière identique ou différente.

6. Procédé selon une des revendications 1 à 5,
caractérisé en ce que
pour réaliser les couches de liaison, un gaz réactif est introduit pendant l'opération d'évaporation.

7. Procédé selon les revendications 1 à 6,
caractérisé en ce que
le rapport de la puissance électrique des faisceaux d'électrons à la puissance de la décharge électrique est réglé librement.

8. Procédé selon les revendications 1 à 7,
caractérisé en ce qu'
on applique un potentiel choisi librement au substrat à évaporer.

9. Procédé selon la revendication 8,
caractérisé en ce qu'
au substrat à évaporer on applique une tension continue négative par rapport aux creusets,.

10. Procédé selon la revendication 8,
caractérisé en ce que
les substrats évaporés reçoivent une tension continue négative impulsionnelle de forme, amplitude, durée et intervalle entre les impulsions réglables par rapport à la tension appliquée aux creusets d'évaporation.

11. Procédé selon au moins l'une des revendications 1 à 10,
caractérisé en ce que
la tension alternative de décharge et la tension de substrat, pulsée, sont synchronisées pour avoir des passages à zéro simultanés et la fréquence de la tension du substrat est double de la fréquence de la tension alternative de décharge.
